# EUROPEAN PATENT SPECIFICATION

(11) **EP 3 584 833 B1**
(45) Date of publication and mention of the grant of the patent: **01.09.2021**
(21) Application number: 18305763.7
(22) Date of filing: 19.06.2018
(51) Int. Cl.: H01L 23/498, H01L 21/48, H01L 23/538

(54) **POWER MODULE WITH IMPROVED ALIGNMENT**
LEISTUNGSMODUL MIT VERBESSERTER AUSRICHTUNG
MODULE DE PUISSANCE À ALIGNEMENT AMÉLIORÉ

(43) Date of publication of application: 25.12.2019
(73) Proprietor: Mitsubishi Electric R&D Centre Europe B.V., 1119 NS Schiphol Rijk Amsterdam (NL); Mitsubishi Electric Corporation, Tokyo 100-8310 (JP)
(72) Inventor: MRAD, Roberto, 35708 RENNES Cédex 7 (FR); PERRIN, Rémi, 35708 RENNES Cédex 7 (FR); MORAND, Julien, 35708 RENNES Cédex 7 (FR); EWANCHUK, Jeffrey, 35708 Rennes cedex 7 (FR); MOLLOV, Stefan, 35708 RENNES Cédex 7 (FR)
(74) Representative: Plasseraud IP

(56) References cited:
- EP-A1- 2 804 209
- WO-A1-2015/077808
- DE-A1-102007 041 926
- DE-A1-102008 040 906
- US-A1- 2013 221 526

## Description

### FIELD OF THE INVENTION

The invention relates to an electrical power assembly comprising a power die embedded in an insulating core, the power assembly providing a better connection and alignment of the power die to a substrate. The invention also relates to a manufacturing method of the power assembly, and to a power module comprising one or two substrates assembled to said electrical power assembly.

### TECHNICAL BACKGROUND

WO2015077808 discloses a circuit board structure for mounting a power component.

Power dies, such as diodes or various types of transistors (MOSFET, JFT, IGBT...) are elementary components of power modules which are used for the control and conversion of electric power, for instance in applications such as the automotive or aeronautic industries.

Currently the most common way to connect a power die to other components, for instance in a power module, is by using an insulated plate such as Direct Bonded Commer (DBC) Substrate, which comprises a ceramic tile covered on at least one side with a sheet of copper. Power dies are soldered or sintered on the DBC Susbtrate on one side, and connected on the other side of the die by wire bonds or ribbons of aluminum that are ultrasonic welded on the die metallization.

The constant increase in switching frequency and power density of power dies leads to a constant need for thermal enhancement, volume reduction and reliability increase of power modules.

In this perspective, the traditional connection by wire bonding of a power die on a substrate has a number limitations and drawbacks, among which the serial and long manufacturing process due to the small size of some dies electrical contacts (in particular gate pads), and the high parasitic level and low reliability of the wire bonds.

It has recently been proposed power modules which comprise two cooling substrates such as DBCs, between which are sandwiched power dies.

For instance, document US6442033 discloses a power module comprising two insulated metal substrates, between which are interposed a plurality of power devices. As another example, document US8432030 discloses a power electronic package comprising two substrates between which are mounted multiple power dies. The substrates comprise raised regions or posts providing electrical and mechanical connections between the substrates, and/or between the substrates and the power dies.

The modules proposed in these documents eliminate the need for wire bonds, thereby exhibiting higher reliability, and provide double sided cooling.

However, these modules are quite complex to manufacture, because of the very small size of the power dies electrodes, and in particular of the gate pads. It is indeed quite complicated to align the power dies electrical contacts with two substrates, especially when the substrates comprise thick copper layers, which is the case for many power electronic applications.

Another emerging technology is to manufacture pre-packed power cells, comprising at least one power die embedded in a PCB laminate. It is for example known from document US 9425131 a packaged structure comprising at least one power die embedded in a PCB substrate and connected to conductive layers through vias.

This type of package allows easier connection of the power die's electrical contact on a substrate. In addition, the embedding of the die inside a substrate reduces the mechanical stresses on the die during assembly stage and increases the reliability and lifetime of the die.

However, in such pre-package power cell, the power devices are connected by vias on the device pads through insulated layers. Even with high number of copper vias which is usually limited by manufacturing capabilities, the connection layer made of copper vias and insulation material presents a high thermal resistance compared to the direct contact by soldering and silver sintering in traditional power modules. In addition, in order to obtain higher thermal and electrical performances of the power cell, it is preferable to have vias filled with copper and a thicker copper layer on the pre-packaged cell. This required longer copper plating time which increases significantly the manufacturing time and cost.

### DESCRIPTION OF THE INVENTION

The invention aims at solving at least part of the problems listed above. In particular, the invention aims at providing a package for a power die allowing easy connection to the power die for power application.

Another aim of the invention is to propose an electrical power assembly providing easy alignment relative to a substrate.

Another aim of the invention is to propose a power module which is easier and less expensive to manufacture.

Accordingly, a power module according to claim 1 is disclosed. Additional features are specified in dependent claims 2-7.

In an embodiment, the power module comprises two substrates each comprising a layer of thermally conductive and electrically insulating material and a layer of electrically conductive material having a post protruding thereof, and wherein the electrical power assembly comprises open cavities on opposite sides thereof, the power assembly being mounted between the two substrates with each post of a substrate being inserted in a respective cavity of the power cell, and the power module further comprises electrically isolating material filling the spaces remaining between the substrates.

According to another object of the invention, a method according to claim 8 Z for manufacturing a power module is disclosed. Additional features are specified in dependent claims 9-13.

An electrical power assembly according to the invention provides a number of advantages. Indeed, the electrical power assembly according to the invention comprises at least an open cavity which simultaneously plays two roles. The first role of the open cavity is to expose an electrical contact of the power die, thereby allowing its direct connection to a substrate. This direct connection allows transmission of high power with a low manufacturing cost.

It is thus not necessary to provide a thick copper layer for connecting the power die to the substrate, and the manufacturing process of the power assembly is therefore quicker and cheaper.

In some embodiments, the bottom and walls of the cavity may also be plated to connect the power die electrical contact with the surface layer of electrically conductive material of the power assembly. This can allow easy connection, for instance between several components embedded in the assembly.

The other role of the open cavity is to facilitate the subsequent alignment of the power assembly with a substrate, because the substrate can comprise a corresponding post adapted to be inserted in the open cavity to provide electrical connection between the substrate and the power die.

A power module comprising at least one substrate and such an electrical power assembly is thus easier to align and assemble.

For enhanced thermal dissipation, a double sided cooling power module can be obtained by positioning a power assembly having cavities formed on opposite sides of the power die between two substrates, each substrate having posts shaped to be inserted into the corresponding cavities.

### DESCRIPTION OF THE DRAWINGS

Other features and advantages of the invention will be apparent from the following detailed description given by way of non-limiting example, with reference to the accompanying drawings, in which:
- Figures 1a and 1b represent two examples of electrical power assemblies comprised in the power module according to claim 1,
- Figures 2a to 2f schematically represent an example of a method for manufacturing an electrical power assembly comprised in the power module according to claim 1,
- Figures 3a to 3e schematically represent an example of a method for manufacturing a power module according to an embodiment of the invention.
- Figure 4 represents an example of a power module according to an embodiment of the invention.
- Figure 5 is the electrical diagram of an elementary power assembly comprising an IGBT and a diode.
- Figure 6 schematically illustrates the main steps of a method of manufacturing an electrical power assembly comprised in the power module according to claim 1,
- Figure 7 schematically illustrates the main steps of a method of manufacturing a power module according to an embodiment of the invention.

### DETAILED DESCRIPTION OF AT LEAST ONE EMBODIMENT OF THE INVENTION

### Electrical power assembly

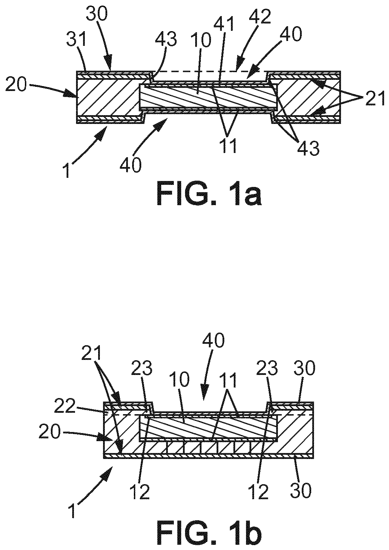

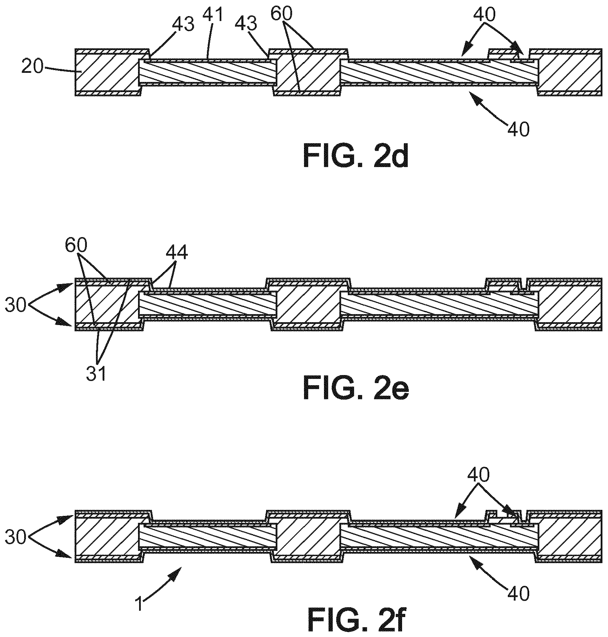

With reference to figures 1a, 1b and 2f, an electrical power assembly 1 comprised in the power module according to claim 1 will now be described. The electrical power assembly 1 is used as an elementary component for integration in a power module and/or a power converter as will be explained in more details below.

The electrical power assembly 1 comprises a power die 10. The power die may be a diode or a transistor such as a MOSFET, JFET or IGBT. In embodiments, the power die 10 is made from silicon semiconductor or a wide bandgap semiconductor, i.e. a semiconductor having a bandgap in the range of 2-4 eV. For instance, the power die may be made in Silicon Carbide SiC or in Gallium Nitride GaN.

The power die has at least two electrical contacts 11. The electrical contacts are metallic pads made of any suitable metal such as aluminum, gold, copper, silver, etc. The power die may be a lateral component in which the electrical contacts 11 are arranged on a same side of the die. Else, the power die may be a vertical component in which the electrical contacts 11 are arranged on opposite sides of the die.

For instance, the power die 10 can be a diode having two opposite electrical contacts 11. According to another example, the power die 10 can be a transistor having three electrical contacts comprising a gate, a source, and a drain, or a gate, an emitter and a collector, according to the type of transistor.

The electrical power assembly may comprise at least one additional power die or a sensor such as a temperature sensor, a field sensor, a current sensor, or other, or at least one passive component such as a resistor, a capacitor, or other, connected to the first power die 10. In case of at least two power dies 10 included in the electrical power assembly, the power dies can be of different types and references, have different orientations and different thicknesses.

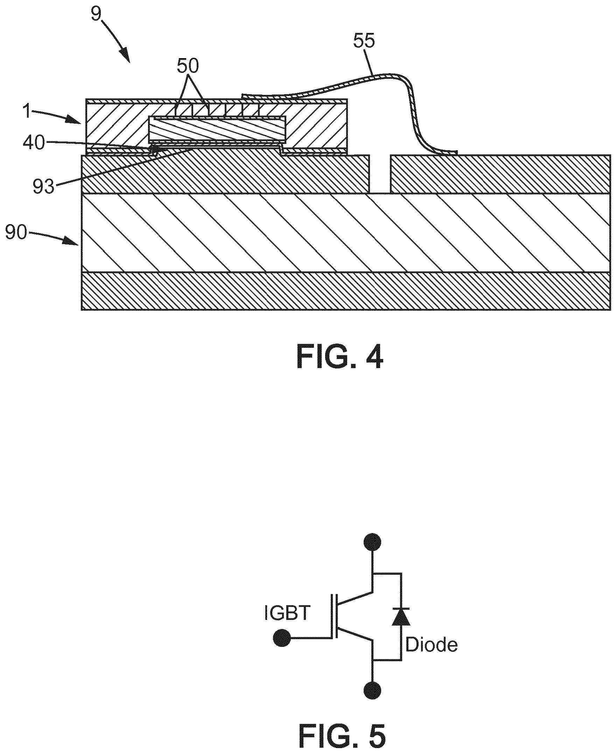

A non-limiting example is shown schematically in figure 2f, in which the electrical power assembly 1 comprises an IGBT 10' having on a top side a gate and an emitter and on a bottom side a collector, and a diode 10 having a top pad as an anode, connected to the emitter, and a bottom pad as a cathode, connected to the collector. Due to this arrangement the electrical power assembly 1 forms a switch to be used in a power module, corresponding to the electrical diagram shown in figure 5.

The electrical power assembly 1 comprises an electrically insulating core 20, in which the, or each power die 10, is embedded. The power die 10 is embedded in the insulating core 20 such that each electrical contact of the power die extends along a plane which is substantially parallel to a main plane along which extends the core.

Moreover, if the power die 10 comprises opposite electrical contacts 11 extending parallel to one another, the direction extending between the contacts and being orthogonal to each contact is also orthogonal to the main plane along which extends the electrically insulating core. This is the case in the figures in which the power dies are shown having a vertical arrangement, while the insulating core extends along a horizontal plane.

The material of the electrically insulating core is preferably chosen as having low thermal resistance to provide better heat dissipation.

As non-limiting examples, the electrically insulating core 20 may be made of of epoxy resin such as FR-4 glass epoxy, of polyimide, or in ceramic such as HTCC (High-Temperature Co-fired Ceramic) or LTCC (Low Temperature Co-fired Ceramic).

The electrically insulating core 20 comprising the power die 10 extends sensibly along a plane and defines two opposite main surfaces 21 which extend substantially along said plane.

The electrical power assembly 1 further comprises two surface layers 30 of electrically conductive material on opposite main surfaces of the insulating core 20. The material of these layers is a metal, preferably copper.

Each electrical contact 11 of the power die 10 is connected to one of the surface layers 30. If two electrical contacts 11 are located on the same side of the die 10, they can be connected to the same surface layer and, if required electrically, the latter is preferably patterned to disconnect the two electrical contacts.

As shown in figures 1a, 1b and 2f, the electrical power assembly 1 also comprises at least one open cavity 40 extending from an electrical contact 11 of the power die 10, through the electrically insulating core 20 and the surface layer of electrically conductive material 30 covering the insulating core 20.

By open cavity 40 it is understood that the cavity has a bottom 41 and an open end 42 opposite its bottom. The bottom 41 of the open cavity is formed by a portion of the electrical contact 11 of the power die, which is therefore exposed by the open cavity.

The cavity has walls 43 extending from the bottom 41 to its open end 42, wherein each wall is formed 42 in part by a thickness 22 of the electrically insulating core 20 extending between the power die 10 and the main surface 21 of the electrically insulating core located on the same side of the power die 10 as the open cavity 40, and in part by the surface layer 30 of electrically conductive material covering said side of the insulating core 20.

The shape of the open cavity 40, as seen looking towards the bottom of the cavity, is indifferent, i.e. it can be a square, a rectangle, a U-shape, a L-shape, or it can be round, etc., but as will be explained in more detailed below, is preferably chosen to make the alignment of the power assembly on a substrate easier.

Additionally, the shape and profile of the cavity are advantageously configured to optimize electrical and thermal transports between the electrical power assembly and a substrate later assembled with the assembly.

Preferably, the portion of the electrical contact 11 of the power die 10 that is exposed by the open cavity has a surface comprised between 1 and 100% of the surface of the electrical contact. If there is only one open cavity exposing a portion of the electrical contact, the surface of the portion exposed by said cavity is preferably comprised between 10 and 100% of the surface of the electrical contact 11, and preferably between 50 and 100% of the surface of the electrical contact 11.

Several adjacent cavities may also be formed in the electrical power assembly to expose respective portions of a same electrical contact of the power die. In that case, the surface of the electrical contact exposed by each cavity is at least 1% of the surface of the electrical contact, and the cumulative surface of the electrical contact exposed by the cavities is comprised between 10 and 100% of the surface of the electrical contact, and preferably between 50 and 100% of the surface of the electrical contact.

In addition, the open cavity 40 is shaped such that the power die 10 extends further than at least two opposite walls 43 of the cavity 40, and, in an embodiment, such that a peripheral edge of the power die is not exposed by the cavity.

Due to this configuration, the electrically insulating core 20 comprises a rim 23 covering at least two opposite edges 12 of the power die, and preferably covering a peripheral edge of the power die, thereby maintaining the power die in its position in the electrically insulating core 10.

In preferred embodiments, the open cavity 40 is further at least partially plated with electrically conductive material (preferably copper) in order to connect the power die electrical contact 11 which is exposed by the open cavity to the surface layer 30 of electrically conductive material of the assembly 1.

Thus, the power assembly 1 exhibits a contact pad for its connection to a substrate, which comprises at least the bottom of the cavity, the portion of the surface layer of electrically conductive material 30 to which it is connected and the plated part of the side walls 43 of the cavity.

Preferably, the open cavity 40 may be fully plated, i.e. the bottom of the cavity formed by the exposed area of the power die electrical contact, and the side walls of the cavity, may be fully plated, in order to increase a connection surface of the open cavity.

Moreover, in the case where the power die 10 comprises a gate pad or any other small pads such as on-chip sensor or temperature sensors, the size of the gate pad may be too small to form an open cavity exposing the gate pad. Thus in order to allow connection of the gate pad, the latter may be connected to the surface layer 30 of electrically conductive material by at least one via, obtained for instance by laser drilling. In that case the plating of the assembly 1 is also performed in order to plate the via and achieve the connection of the gate pad to the surface layer 30.

The layer of electrically conductive material resulting from the plating of the bottom and side walls of the cavity is shown in the figures with reference 44.

The metal of the electrical power assembly 1, i.e. the metal of the surface layer 30 and the metal used for the plating step is preferably copper, but it can be other material like silver. The assembly pads can also be finished by other metals in order to create a protection against oxidation, humidity, migration or other. These metals can be nickel, silver, tin or gold which can be deposited by any method like chemical, vaporization or other.

As will be explained in more details below, and as is the case in the examples of figure 1a, 1b and 2d, the surface layer 30 of electrically conductive material located on the side of the power assembly in which the open cavity is located can comprise a superficial thickness 31 resulting from the plating of the whole side of the cell 1 in which the open cavity 40 is arranged. In that case, the assembly 1 has a contact pad comprising the plated surface layer 30, and the plated bottom 41 and walls 43 of the cavity 40.

The thickness of the plating layer, either in the cavity or on a main surface of the assembly, is preferably comprised between 2 and 100 µm, for instance about 10 µm.

Open cavities 40 may be formed in the electrical power assembly 1 on opposite sides of the assembly in order to expose respective portions of opposite electrical contacts 11 of the power die 10 embedded in the insulating core 20. Alternatively, one electrical contact may be exposed thanks to an open cavity 40, and an opposite electrical contact 11 of the power die may be connected to an opposite surface layer 30 thanks to through vias 50 arranged in the electrically insulating core 20, as in the example shown in figure 1b.

In addition, if the assembly comprises at least one additional power die 10 or one or more passive components, several open cavities 40 can be arranged on a same side of the cell to expose respective portions of the electrical contacts of the components embedded in the insulating core.

In that case, the surface layer 30 of electrically conductive material which is connected to the electrical contacts of the components is preferably patterned to isolate electrical contacts of different components where applicable. In cases where a connection is desired between the electrical contacts of the components, the plating layer provides said connection.

If the power die 10 embedded in the power assembly is a lateral component having all electrical contacts on the same side of the power die, the electrical power assembly 1 may also comprise at least one open cavity extending from the side of the power die devoid of electrical contacts, through the insulating core and corresponding surface layer. Said open cavity can then be used for cooling of the power die as explained below.

This is the case in the example shown in figure 2f of an electrical power assembly corresponding to the electrical diagram of figure 5. In this example the electrical power assembly 1 comprises, on a top surface, a first open cavity 40 exposing the anode of the diode 10, a second open cavity 40 exposing the emitter of the IGBT 10', and a via exposing the gate of the IGBT 10'.

The top surface of the assembly is fully plated, such that the bottom 41 and side walls 43 of each cavity 40 are plated, and the assembly 1 comprises a surface layer 30 of electrically conductive material resulting from the platting. Further, this surface layer is patterned to isolate on the one hand the anode of the diode and emitter of the IGBT (which are connected together) and on the other hand the gate of the IGBT.

The bottom side of the assembly also comprises an open cavity 40 exposing the cathode of the diode 10, and an open cavity exposing the collector of the IGBT 10'. The bottom side is plated such that bottom 41 and side walls 43 of each cavity are plated, and the assembly comprises a surface 30 layer of electrically conductive material resulting from the platting. This layer needs not be patterned because it connects together the cathode and the collector.

According to another example shown schematically in figure 1a, the electrical power assembly 1 comprises a single power die, for instance a diode, having two opposite electrical contacts 11, and the assembly comprises two opposite open cavities 40 exposing respective portions of the opposite electrical contacts 11.

According to still another example shown schematically in figure 1b, the electrical power assembly 1 comprises a single power die 10 having two opposite electrical contacts 11, and the assembly comprises one open cavity 40 exposing a portion of one electrical contact 11. On the other side of the assembly, a surface layer 30 of electrically conductive material is connected to the other electrical contact 11 of the power die by through vias 50.

Any of the described elementary assemblies can have at least one through hole via that connects at least part of the top conductive layer 30 to at least part of the bottom conductor layer 30 in order to transport at least one electric contact from one side of the assembly to the other side of the assembly (top to bottom or vice versa), or in order to duplicate on the conductor layers 30 located on both sides of the assembly at least one electric contact which originally exist on one side of the at least one power device. The size and number of the through hole vias of the at least one electric contact to be transported or duplicated is chosen according the current level to be conducted on these vias.

### Manufacturing method of an electrical power assembly

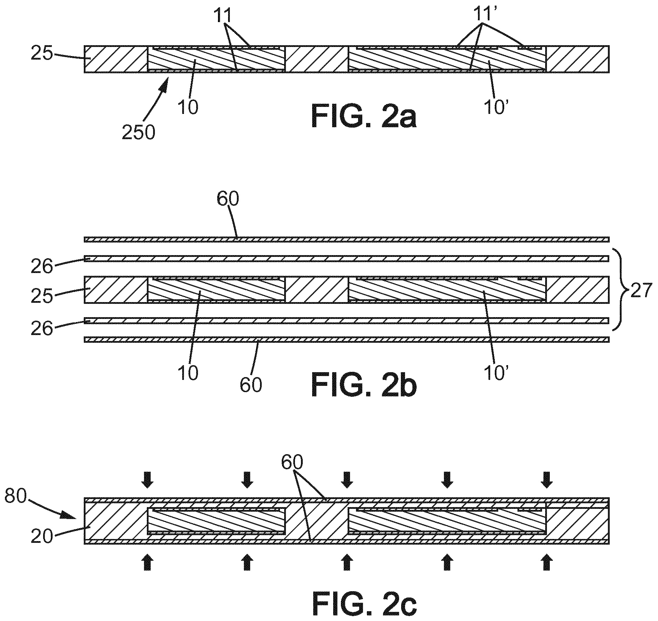

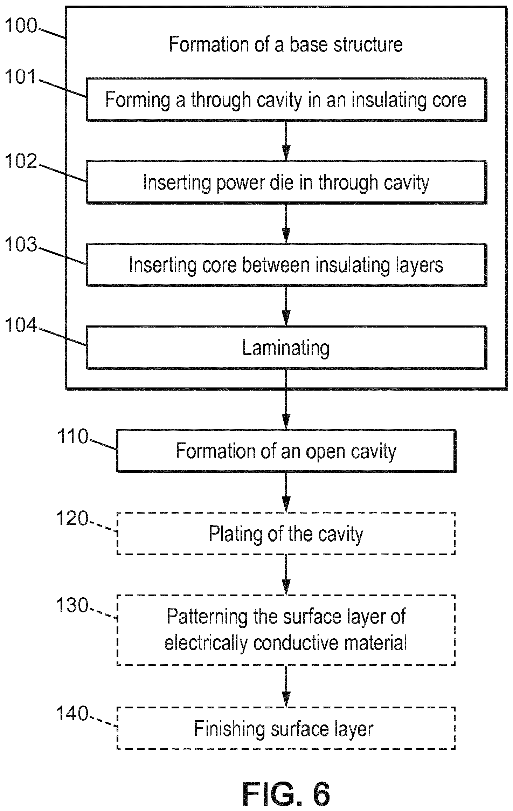

With reference to figures 2a to 2f and to figure 6, a manufacturing method of an electrical power assembly will now be described.

The method comprises a first step 100 of forming a base structure 80 comprising at least an electrically insulating core 20, and layers 60 of electrically conductive material covering opposite main surfaces of the electrically insulating core 20, the insulating core 20 embedding at least one power die 10.

As already indicated above, the material of the electrically insulating core is preferably chosen has having low thermal resistance to provide better heat dissipation.

As non-limiting examples, the electrically insulating core 20 may be made of of epoxy resin such as FR-4 glass epoxy, of polyimide, or in ceramic such as HTCC (High-Temperature Co-fired Ceramic) or LTCC (Low Temperature Co-fired Ceramic).

The power die 10 may be a diode or a transistor such as a MOSFET, JFET or IGBT, and can have the various configurations of electrical contacts 11 already detailed above.

The electrical power assembly may comprise at least one additional power die, or a sensor such as a temperature sensor, field sensor, current sensor, or other, or at least one passive component such as a resistor, a capacitor, or other, connected to the first power die 10. In case of at least two power dies 10 included in the electrical power assembly, the power dies can be of different types and references, have different orientations and different thicknesses.

In the non-limiting examples of figures 2a to 2f, the base structure 80 comprises an IGBT 10' and a diode 10, embedded in respective cavities of the electrically insulating core 20. The diode has two electrical contacts 11, namely an anode and a cathode, and the IGBT has three electrical contacts 11', an emitter, a gate and a collector.

The diode is inserted in the cavity of the insulating core 20 such that the anode is oriented towards the same main side of the insulating core 20 than the gate and emitter of the IGBT, i.e. towards the top side in the figures.

The base structure 80 may be a PCB where the layer of electrically conductive material is made of copper and the electrically insulating core 20 is made of FR4, in which each power die is embedded.

In that case, the base structure 80 can be obtained during step 100 by implementing a first sub-step 101 of forming at least one through-cavity 250 in a base layer 25 of electrically insulating material, the through-cavity 250 having the shape and dimensions of a power die to be embedded in the assembly.

The through-cavity may be obtained for instance by mechanical drilling, milling, stamping or even laser cutting.

The step 100 then comprises a sub-step 102 of inserting the power die 10 in the through-cavity 250, or as the case may be each power die 10, 10' in a respective cavity. Each power die inserted in a respective cavity is oriented such that each electrical contact 11 of the die extends parallel to the plane of the base layer 25 of electrically insulating material. In the figures, in which the layer 25 of electrically insulating material extends horizontally, the electrical contacts 11 also extend horizontally, each contact facing upwardly or downwardly. In other words, after this step 120 during which the power die is inserted in a through-cavity of the layer 21, the electrical contacts of the die are exposed and are not facing a side wall of the through-cavity 250.

An exemplary implementation of this step is shown for instance in figure 2a.

With reference to figure 2b, the step 100 then comprises a sub-step 103 of inserting the base layer 25 comprising each power die 10 between two additional layers 26 of electrically insulating material of the same material than the first one, to obtain a stack 27 of electrically insulating material that will then become the electrically insulating core 20. During this sub-step 103, two layers 60 of electrically conductive material such as copper are also provided, and the stack 27 of electrically insulating material is inserted between the two layers 60 of electrically conductive material.

With reference to figure 2c, during a sub-step 104, the stack 27 of electrically insulating material and the conductive layers 60 are laminated in order to form the base structure 80, in which the layers of the stack 27 are fused together to form the electrically insulating core 20.

Given the orientation of the power die 10 when inserted in the through-cavity of the insulating base layer 25, the electrical contacts of the power die are thus covered successively with a layer a layer 26 of electrically insulating material, and a layer 60 of electrically conductive material.

With reference to figure 2d, the method then comprises a step 110 of forming at least one open cavity 40 in the base structure 80, the open cavity 40 exposing a portion of an electrical contact 11 of the power die 10 embedded in the insulating core 20. This step thus comprises the removal, from the base structure 80, of a stack comprising a portion of the electrically insulating core 20 adjacent the electrical contact 11 of the power die, and a corresponding portion of the layer 60 of electrically conductive material covering said portion of the core 20.

Preferably, and as already mentioned above, the portion of the electrical contact 11 of the power die 10 exposed by the open cavity 40 after removal of this stack has a surface comprised between 10 and 100% of the surface of the electrical contact, and even more preferably between 50 and 100% of the surface of the electrical contact.

Indeed, exposed portion is preferably as large as possible in order to maximize the electrical and thermal contact surface of the assembly 1.

For power dies having electrical contacts of large dimensions (such as, for instance...), a plurality of open cavities 40 can be made in the base structure to expose respective portions of a same electrical contact 11. This can be easier to implement than forming a single open cavity 40 exposing a large surface of the electrical contact.

In that case, the surface of the electrical contact exposed by each cavity is comprised between 1 and 100% of the surface of the electrical contact, and the cumulative surface of the electrical contact exposed by the cavities is preferably comprised between 10 and 100% of the surface of the electrical contact, and even more preferably between 50 and 100% of said surface.

However, preferably the power die 10 has to remain maintained in position by the electrically insulating core 20 after formation of the open cavity 40. Therefore the open cavity 40 is dimensioned so as not to expose more than the electrical contact 11 of the power, and in particular the bottom 41 of the open cavity 40 cannot extend over the whole surface of the side of the power die on which the electrical contact is arranged.

More specifically, the open cavity 40 is shaped such that the power die 10 extends further than at least two opposite walls 43 of the cavity 40, and, in an embodiment, such that a peripheral edge of the power die is not exposed by the cavity.

The electrically insulating core thus comprises, as shown in the example of figure 2 d, after formation of the cavity, at least two opposite edges 23 and optionally a peripheral edge adjacent the power die 10 and forming the base of the side walls 43 of the open cavity 40.

With reference to figure 2e, the method then preferably comprises a step 120 of plating at least partially the open cavity 40 with electrically conductive material, which can be a metal and is preferably copper, in order to connect the exposed electrical contact 11 of the power die 10 to the layer 60 of electrically conductive material of the base structure. The plating may be performed by electro less or/and electro plating.

Therefore, at least part of the side walls 43 of the open cavity 40, extending from the bottom 41 of the cavity formed by the electrical contact 11 to the layer 60 of electrically conductive material, may be plated.

In an embodiment, only the side walls, and possibly the bottom of the cavity 40 are plated. In that case, the surface layer of the obtained electrical power assembly is formed by the layer 60 of electrically conductive material of the base structure.

According to a preferred embodiment, the open cavity 40 as well as the layer 60 of electrically conductive material of the base structure may be fully plated by deposition of an electrically conductive material such as copper. This embodiment is elected if the power die 10 comprises a gate pad, and a through via is formed in the electrically insulating core to access the gate pad. In that case the plating also allows electrically connecting the gate pad to the layer 60 of electrically conductive material thanks to the via.

If the side of the base structure having the open cavity is fully plated, the surface layer 30 of the obtained electrical power assembly 1 is formed by the layer 60 of conductive material of the base structure on top of which is an additional thickness 31 of electrically conductive material which results from the plating.

Thanks to the method, the connection surface for enabling connection to the electrical contact of the power die is enlarged because it comprises:
- The portion of the electrical contact of the power die exposed by the open cavity (which can be plated),
- The plated walls of the cavity, and
- The surface layer 30 of the base structure which is connected to the electrical contact 11.

This, combined with the direct contact with the power die electrical contact provided by the cavity, makes it not necessary to provide a thick plating layer to allow proper connection to the power die for power applications. For instance, a 5 µm-thick plating layer 31, 44 may be enough for power applications.

The method can then comprise an optional step 130 of patterning the surface layer 30 of electrically conductive material by etching, in order to isolate the electrical contacts that should not be connected together. The etching also may include etching the outer edges of layer 30 in order to increase the isolation distance between the opposite layers 30 of conductive material.

This method can also comprise an optional step 140 of finishing the surface layer 30 by a different metal. This helps protecting the metal of layer 30 from different phenomena like oxidation or migration. The finish metal can be silver, gold, tin, titanium, nickel, chrome or other. The finish layer can be made of different metals or different layer of metals.

In the example shown in figure 2f, where the electrical power assembly comprises a diode and an IGBT, and the assembly comprises open cavities exposing respectively the anode, emitter and gate of the diode and IGBT, the anode and emitter of the IGBT are connected together but the gate has to be isolated from the other electrical contacts. Therefore the patterning step is performed to remove a portion of the external layer of electrically conductive material connecting together the gate and other electrodes.

### Power module

Once a electrical power assembly 1 is obtained, it may be integrated into a power module 9 in order to be connected to other components.

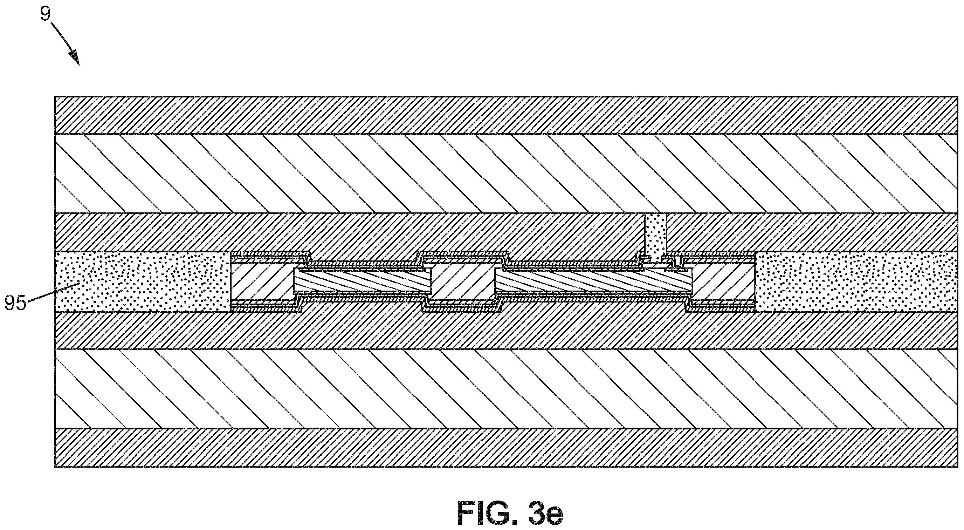

With reference to figures 3e and 4, the power module 9 may comprise at least one substrate 90 comprising at least a layer 91 of electrically conductive material, and a layer 92 of thermally conductive material, which is also electrically insulating.

The substrate may for instance be a Direct Bonded Copper (DBC) substrate, in which a patterned layer of copper is arranged on a ceramic plate (for instance made of alumina), forming the thermally conductive and electrically insulating layer. According to other examples, the substrate may be an Insulated Metal Substrate (IMS) or an Active Metal Brazed (AMS) Substrate.

The layer 91 of electrically conductive material may be patterned to provide proper electrical connection between various elementary components, and for instance between various power assemblies 1.

The substrate comprises at least one post 93 of electrically conductive material protruding from the layer 91 of electrically conductive material, the post having a shape and dimensions corresponding to the shape and dimensions of a cavity of the elementary power assembly in order to allow insertion of the post inside the cavity of the elementary power assembly, such that insertion of the post inside the cavity allows electrical and thermal connection between the post and the electrical contact 11 of the power die exposed by the cavity.

Therefore, a direct electrical contact is obtained between the power die and the substrate.

In addition, if the open cavity 40 is at least partially plated, insertion of the post inside the open cavity may further allow electrical connection between the post and the plated walls (either bottom wall corresponding to the plated electrical contact of the power die or side walls) of the cavity.

If the main surface of the power assembly 1 on which an open cavity is formed is fully plated, insertion of the post inside the open cavity further allows electrical connection between the surface layer of electrically conductive material of the power assembly and the layer of electrically conductive material of the substrate.

If a power assembly 1 to be connected to the substrate 90 comprises several open cavities 40, the substrate 90 comprises corresponding posts 93 of same sizes and dimensions that the respective cavities.

As already indicated above, the shape of a cavity is indifferent, however the shapes and orientations of various cavities of the power assembly are preferably chosen in order to allow unique orientation of the mating substrate relative to the assembly, and easy fitting to that substrate.

For instance, if an assembly comprises a single cavity, the shape of the cavity is preferably chosen to permit a unique orientation of the substrate relative to the assembly, i.e. the shape may be a U-shape, a L-shape, a triangle, etc.

If an assembly comprises a plurality of cavities, the shapes and orientations of the cavities are chosen to allow unique orientation of the mating substrate.

According to an embodiment, a power module may comprise one such substrate 90 assembled to one side of an electrical power assembly where an open cavity 40 is arranged. If the power die has opposite electrical contacts 11, the opposite contact of the power die which is not exposed by the cavity 40 may be connected to an electrical pad of the assembly arranged on a side of the assembly opposite the cavity, for example by through vias, and the electrical pad may be connected to the substrate by wire bonding, as shown schematically on the example of figure 4.

If the surface layer 30 of electrically conductive material of the assembly that is connected to the electrical contact 11 of the power die by through vias 50 is made of copper, the wire bonds 55 are preferably also made of copper, since it provides better thermal and electrical conductivities.

According to a preferred embodiment the power module 9 comprises two substrates 90 between which is inserted the electrical power assembly 1, to provide double-sided cooling. In that case the electrical power assembly preferably has at least two opposite open cavities 40 exposing respective portions of opposite electrical contacts 11 of the power die 10, and each substrate 90 comprises at least one post 93 shaped to be inserted in a respective cavity of the power die.

In an embodiment where the electrical power assembly comprises a lateral power die having all electrical contacts on the same side, and also comprises at least one cavity for connecting one of the electrical contacts and an additional open cavity extending from the side of the power die devoid of electrical contact, the power module may also comprise two substrates 90 having posts 93 adapted to be inserted in corresponding open cavities, the post inserted in the open cavity on the side of the power die devoid of electrical contact allowing for dissipation of heat generated by the power die.

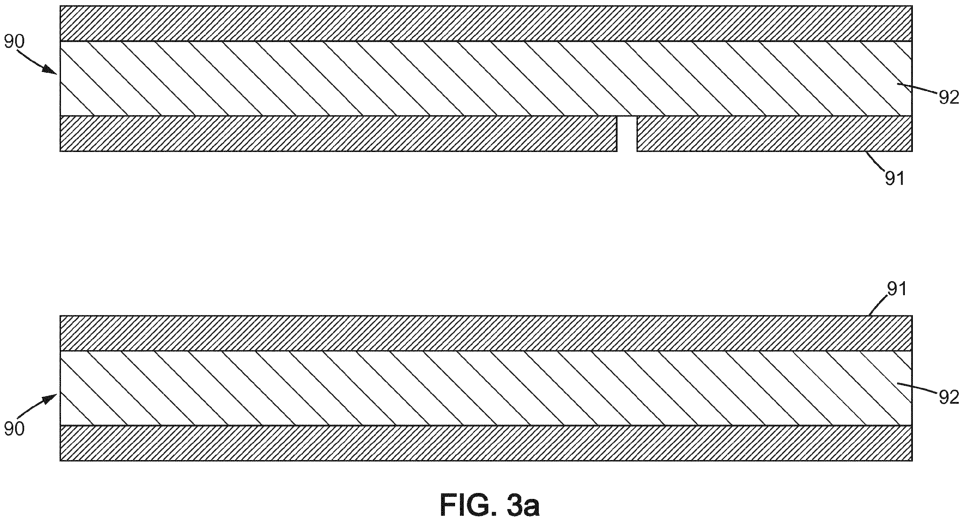

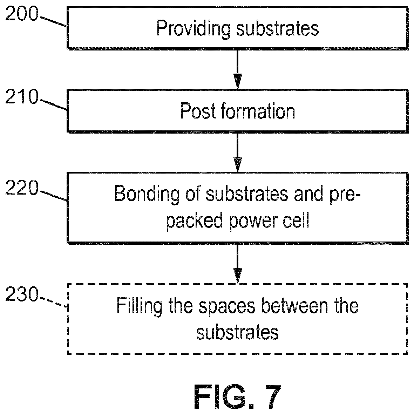

With reference to figures 3a to 3e and 7, a manufacturing method of such a power module comprises a step 200 of providing two substrates 90 comprising each a layer 91 of electrically conductive material and a layer 92 of thermally conductive and electrically insulating material (fig. 3a).

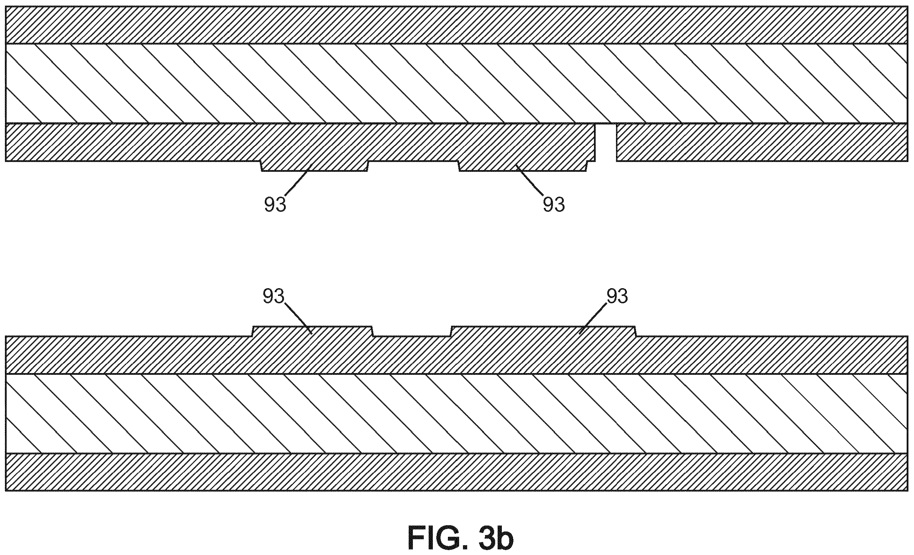

The method then comprises a step 210 of forming at least one post 93 on at least one of the substrates 90 (fig. 3b). Each post 93 may be formed on a respective layer 91 of electrically conductive material either by additive manufacturing, for example by Chemical Vapor Deposition 3D or screen printing or any suitable method, or by subtractive manufacturing, for instance by chemically or mechanically etching a thicker layer of electrically conductive material to obtain the desired posts.

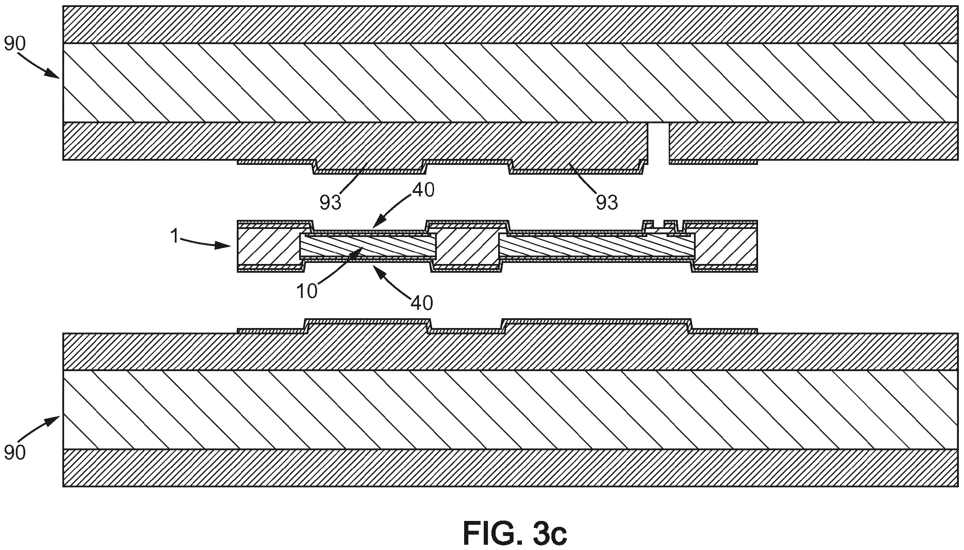

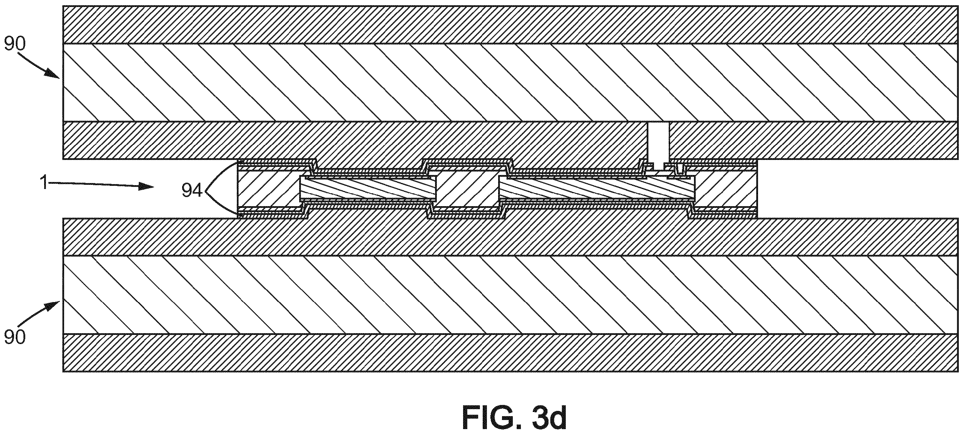

The method then comprises a step 220 of positioning an elementary power assembly between the substrates (fig. 3c), such that each post of a substrate is inserted in a corresponding cavity of the power assembly, and bonding together (fig. 3d) the substrates and power assembly. The bonding may be performed by soldering, sintering, gluing, or the assembly may be pressed to the substrates directly or using a conductive material preform such as molybdenum preform.

Any suitable bonding layer 94 may be deposited in order to perform the bonding, such as conductive glue for gluing, soldering material, or sintering paste such as silver or copper sintering paste. The bonding layer may in that case be deposited on at least a portion of each layer of electrically conductive material of the substrates. The bonding layer 94 may in particular be deposited at least on each post 93 of each layer of electrically conductive material. Preferably, the bonding layer 94 is deposited on all a surface of the electrically conductive material that will then be adhered to an outer surface of the elementary power assembly.

The adhesive material may be sintering paste, such as silver sintering paste.

Preferably, as shown in figure 3e, the method also comprises a step 230 of filling the empty spaces between the substrates by an injectable electrically isolating material 95. Said material can be silicone gel, epoxy, or plastic, etc...In an embodiment, the filling material 95 may also be adhesive in order to hold together both substrates 90.

The power module 9 thus obtained has improved thermal performances compared to traditional PCB embedding as the metal posts not only provide electrical connection to the power die, but they also allow thermal dissipation of the heat generated by the power die. In addition, the use of cavities and corresponding metal posts implies that no thick metal deposition is needed on the elementary power assembly 1, which reduces the time and cost of the manufacturing operation.

Last, the cavities and metal posts improve the alignment of the power dies relative to the substrates that they have to be connected to, because the configuration of the cavities and posts are made in order to easily imbricate the assembly with the substrate.

## Claims

1. A power module (9), comprising an electrical power assembly (1), the electrical power assembly (1) comprising :
- a power die (10), having at least two electrical contacts (11),
- an electrically insulating core (20), wherein the power die (10) is embedded in the electrically insulating core (20), and
- two layers (60, 30) of electrically conductive material on opposite main surfaces of the electrically insulating core (20),
- at least one open cavity (40) extending from an electrical contact (11) of the power die, through the electrically insulating core (20) and the layer (60, 30) of electrically conductive material located on the same side of the power die as the electrical contact, such that the open cavity (40) has a bottom (41) formed by an area of the electrical contact (11) of the power die,
wherein the bottom (41), and side walls (43) of the open cavity (40) are at least partially plated with electrically conductive material to connect said area of the electrical contact (11) of the power die (10) to the layer (60, 30) of electrically conductive material, **characterised in that**
the power module (9) also comprises at least one substrate (90) comprising a layer of thermally conductive and electrically insulating material (92) and a layer (91) of electrically conductive material,
the substrate (90) further comprising at least one post (93) of electrically conductive material protruding from the layer of electrically conductive material (91), and the electrical power assembly (1) being mounted on the substrate (90) such that the post (93) is inserted in the open cavity (40) of the electrical power assembly (1),
said post (93) having a shape and dimensions adapted to the shape and dimensions of the open cavity (40) of the electrical power assembly (1), such that insertion of the post in said open cavity (40) provides electrical and thermal contact between the post (93) and the electrical contact (11) of the power die (10) from which the open cavity (40) extends.

2. A power module (9) according to claim 1, wherein, in the electrical power assembly (1), the layer (60) of electrically conductive material, and the bottom (41) and side walls (43) of the cavity are integrally plated with electrically conductive material.

3. A power module (9) according to any of the preceding claims, wherein the electrical power assembly (1) comprises at least two open cavities (40), each cavity extending from a respective one of the electrical contacts (11) of the power die (10).

4. A power module (9) according to any of the preceding claims, wherein, in the electrical power assembly (1), the surface of the area of the power die electrical contact (11) forming the bottom of the open cavity (40) is comprised between 10 and 100% of the surface of the power die electrical contact (11), and is strictly less than the surface of the side of the power die (10) on which the electrical contact (11) is located.

5. A power module (9) according to any of the preceding claims, wherein the electrical power assembly (1) comprises at least two open cavities (40) extending from a same electrical contact (11) of the power die, each cavity having a bottom formed by a respective area of the power die electrical contact (11),the surface of the area of the electrical contact formed by the bottom of each cavity is comprised between 1 and 100% of the surface of the electrical contact, and the cumulative surface of the areas of the electrical contact forming the bottoms of the cavities is comprised between 10 and 100% of the surface of the electrical contact (11), and is less than the surface of the side of the power die (10) on which the electrical contact (11) is located.

6. A power module (9) according to any of the preceding claims, wherein the post (93) has shapes and dimensions adapted to the shape and dimensions of the open cavity (40) of the electrical power assembly (1), such that insertion of the post in said open cavity (40) further provides electrical contact between the post (93) and the plated walls (43) of the cavity and between the layer of electrically conductive material (91) of the substrate and a surface layer (30) of electrically conductive material of the electrical power assembly (1) adjacent said open cavity (40).

7. A power module (9) according to any of the preceding claims, comprising two substrates (90) each comprising a layer (92) of thermally conductive and electrically insulating material and a layer (91) of electrically conductive material having a post (93) protruding thereof, and wherein the electrical power assembly (1) comprises open cavities (40) on opposite sides thereof,
the power assembly being mounted between the two substrates (90) with each post (93) of a substrate (90) being inserted in a respective cavity (40) of the power assembly (1), and the power module further comprises electrically isolating material filling the spaces remaining between the substrates.

8. A method for manufacturing a power module (9) according to any of the preceding claims, comprising :
- providing (200) two substrates (90), each substrate (90) comprising a layer (92) of thermally conductive and electrically insulating material and a layer (91) of electrically conductive material, and an elementary power assembly (1) having at least an open cavity (40) on opposite main sides thereof,
- on each substrate (90), forming (210) at least one post (93) of electrically conductive material protruding from the layer of electrically conductive material (91), each post (93) having shape and dimensions adapted to the shape and dimensions of a respective open cavity (40) of the elementary power assembly (1),
- mounting the elementary power assembly (1) between the substrates (90) with the post (93) of each substrate being inserted in a corresponding open cavity (40) of the elementary power assembly (1), and bonding (220) together the substrates (90) and the elementary power assembly (1), and
- filling (230) any remaining gap between the substrates with electrically isolating material (95).

9. A method for manufacturing a power module (9) according to claim 8, wherein the electrically isolating material (95) used during the filling step (230) is adhesive in order to hold together the substrates (90).

10. A method for manufacturing a power module (9) according to any of claims 8 or 9, wherein the elementary power assembly is obtained by:
- forming (100) a base structure (80) comprising :
o an electrically insulating core (20),
o a power die (10), having at least two electrical contacts (11), the power die being embedded in the electrically insulating core (20) and,
o two external layers (60) of electrically conductive material on opposite main surfaces of the electrically insulating core (20), and
- forming (110), in the base structure (80), an open cavity (40) exposing an area of an electrical contact (11) of the power die (10), by removing from the base structure (80) a stack comprising a portion of the electrically insulating core (20) adjacent said electrical contact (11), and a portion of the external layer (60) of electrically conductive material covering said portion of the electrically insulating core, and
- plating (120) at least partially the open cavity (40) in order to connect said area of the electrical contact (11) of the power die (10) to the external layer (60) of electrically conductive material.

11. The method according to claim 10, wherein the plating step (200) is performed by depositing an additional layer of electrically conductive material (31) on the side of the base structure in which the open cavity (40) is formed, said additional layer (31) of electrically conductive material covering the external layer (60) of electrically conductive material, a bottom (41) of the open cavity formed by the exposed area of the power die electrical contact (11), and lateral walls (43) of the open cavity (40).

12. A method according to any of claims 10 or 11, wherein the power die (10) has two electrical contacts (11) on a same side thereof, and the method comprises forming open cavities (40) to expose respectively an area of each electrical contact (11) of the same side of the power die,
and the method further comprises, after the plating step (120), a step (130) of patterning the additional layer (31) of electrically conductive material in order to disconnect the two electrical contacts (11) of the same side of the power die (10).

13. A method according to any of claims 10 to 12, wherein the step (100) of forming the base structure (80) comprises:
- forming (101) at least one through cavity (250) of the size of the power die (10) in a base layer (25) of electrically insulating material,
- inserting (102) the power die (10) in the through cavity (250),
- positioning (102) the base layer (25) comprising the power die (10) between two additional layers (26) of electrically insulating material, to obtain a stack (27) of electrically insulating layers, and positioning said stack (27) of electrically insulating layers between two external layers (60) of electrically conductive material, and
- laminating (104) the stack (27) of electrically insulating layers and the external layers (60) of electrically conductive material.

## Patentansprüche

1. Leistungsmodul (9), das eine elektrische Leistungsanordnung (1) aufweist, wobei die elektrische Leistungsanordnung (1) aufweist:
- ein Leistungsbauteil (10), das zumindest zwei elektrische Kontakte (11) aufweist,
- einen elektrisch isolierenden Kern (20), wobei das Leistungsbauteil (10) in den elektrisch isolierenden Kern (20) eingebettet ist, und
- zwei Lagen (60, 30) von elektrisch leitfähigem Material auf entgegengesetzten Hauptoberflächen des elektrisch isolierenden Kerns (20),
- zumindest eine offene Vertiefung (40), die sich von einem elektrischen Kontakt (11) des Leistungsbauteils durch den elektrisch isolierenden Kern (20) und die Lage (60, 30) von elektrisch leitfähigem Material, das an der selben Seite des Leistungsbauteils wie der elektrische Kontakt angeordnet ist, erstreckt, so dass die offene Vertiefung (40) einen Boden (41) aufweist, der durch einen Bereich des elektrischen Kontakts (11) des Leistungsbauteils gebildet ist, wobei
der Boden (41) und Seitenwände (43) der offenen Vertiefung (40) zumindest teilweise mit elektrisch leitfähigem Material beschichtet sind, um den Bereich des elektrischen Kontakts (11) des Leistungsbauteils (10) mit der Lage (60, 30) von elektrisch leitfähigem Material zu verbinden, **dadurch gekennzeichnet, dass** das Leistungsmodul (9) auch zumindest ein Substrat (90) aufweist, das eine Lage aus wärmeleitfähigem und elektrisch isolierendem Material (92) sowie eine Lage (91) von elektrisch leitfähigem Material aufweist,
das Substrat (90) ferner zumindest einen Vorsprung (93) von elektrisch leitfähigem Material aufweist, der von der Lage von elektrisch leitfähigem Material (91) vorsteht, und die elektrische Leistungsanordnung (1) auf dem Substrat (90) derart angeordnet ist, dass der Vorsprung (93) in die offene Vertiefung (40) der elektrischen Leistungsanordnung (1) eingesetzt ist, wobei der Vorsprung (93) eine Form und Dimensionen hat, die an die Form und Dimensionen der offenen Vertiefung (40) der elektrischen Leistungsanordnung (1) angepasst sind, so dass das Einsetzen des Vorsprungs in die offene Vertiefung (40) für einen elektrischen und thermischen Kontakt zwischen dem Vorsprung (93) und dem elektrischen Kontakt (11) des Leistungsbauteils (10), von dem sich die offene Vertiefung (40) erstreckt, herstellt.

2. Leistungsmodul (9) nach Anspruch 1, wobei in der elektrischen Leistungsanordnung (1) die Lage (60) von elektrisch leitfähigem Material und der Boden (41) und Seitenwände (43) der Vertiefung integriert mit elektrisch leitfähigem Material beschichtet sind.

3. Leistungsmodul (9) nach einem der vorhergehenden Ansprüche, wobei die elektrische Leistungsanordnung (1) zumindest zwei offene Vertiefungen (40) aufweist, wobei sich jede Vertiefung von einem jeweiligen der elektrischen Kontakte (11) des Leistungsbauteils (10) erstreckt.

4. Leistungsmodul (9) nach einem der vorhergehenden Ansprüche, wobei in der elektrischen Leistungsanordnung (1) die Oberfläche des den Boden der offenen Vertiefung (40) bildenden Bereichs des elektrischen Leistungsbauteilkontakts (11) zwischen 10 und 100% der Oberfläche des elektrischen Leistungsbauteilkontakts (11) aufweist, und strikt kleiner ist als die Oberfläche jener Seite des Leistungsbauteils (10), auf der der elektrische Kontakt (11) angeordnet ist.

5. Leistungsmodul (9) nach einem der vorhergehenden Ansprüche, wobei die elektrische Leistungsanordnung (1) zumindest zwei offene Vertiefungen (40) aufweist, die sich von einem selben elektrischen Kontakt (11) des Leistungsbauteils erstrecken, wobei jede Vertiefung einen Boden aufweist, der durch einen jeweiligen Bereich des elektrischen Leistungsbauteilkontakts (11) gebildet ist, wobei die Oberfläche des durch den Boden jeder Vertiefung gebildeten Bereichs des elektrischen Kontakts zwischen 1 und 100% der Oberfläche des elektrischen Kontakts aufweist, und die kumulative Oberfläche der die Böden der Vertiefungen bildenden Bereiche des elektrischen Kontakts zwischen 10 und 100% der Oberfläche des elektrischen Kontakts (11) aufweisen, und kleiner ist als die Oberfläche jener Seite des Leistungsbauteils (10), auf der der elektrische Kontakt (11) angeordnet ist.

6. Leistungsmodul (9) nach einem der vorhergehenden Ansprüche, wobei der Vorsprung (93) Formen und Dimensionen hat, die an die Form und Dimensionen der offenen Vertiefung (40) der elektrischen Leistungsanordnung (1) angepasst sind, so dass das Einsetzen der Vorsprung in die offene Vertiefung (40) ferner für einen elektrischen Kontakt zwischen der Vorsprung (93) und den beschichteten Wänden (43) der Vertiefung und zwischen der Lage von elektrisch leitfähigem Material (91) des Substrats und einer der offenen Vertiefung (40) benachbarten Oberflächenlage (30) von elektrisch leitfähigem Material der elektrischen Leistungsanordnung (1) herstellt.

7. Leistungsmodul (9) nach einem der vorhergehenden Ansprüche, das zwei Substrate (90) aufweist, die eine Lage (92) von thermisch leitfähigem und elektrisch isolierendem Material sowie eine Lage (91) von elektrisch leitfähigem Material, von der ein Vorsprung (93) vorsteht, aufweisen, und wobei die elektrische Leistungsanordnung (1) an ihren entgegengesetzten Seiten offene Vertiefungen (40) aufweist,
wobei die Leistungsanordnung zwischen den zwei Substraten (90) angebracht ist, wobei jeder Vorsprung (93) eines Substrats (90) in eine jeweilige Vertiefung (40) der Leistungsanordnung (1) eingesetzt ist, und das Leistungsmodul ferner elektrisch isolierendes Material aufweist, das die zwischen den Substraten verbleibenden Zwischenräume füllt.

8. Verfahren zur Herstellung eines Leistungsmoduls (9) nach einem der vorhergehenden Ansprüche, welches aufweist:
- Bereitstellen (200) von zwei Substraten (90), wobei jedes Substrat (90) eine Lage (92) von thermisch leitfähigem und elektrisch isolierendem Material sowie eine Lage (91) von elektrisch leitfähigem Material aufweist, sowie einer elementaren Leistungsanordnung (1), die an ihren entgegengesetzten Hauptseiten zumindest eine offene Vertiefung (40) aufweist,
- auf jedem Substrat (90), Ausbilden (210) von zumindest einem Vorsprung (93) von elektrisch leitfähigem Material, der von der Lage von elektrisch leitfähigem Material (91) vorsteht, wobei jeder Vorsprung (93) eine Form und Dimensionen hat, die an die Form und Dimensionen einer jeweiligen offenen Vertiefung (40) der elementaren Leistungsanordnung (1) angepasst sind,
- Anbringen der elementaren Leistungsanordnung (1) zwischen den Substraten (90), wobei der Vorsprung (93) jedes Substrats in eine entsprechende offene Vertiefung (40) der elementaren Leistungsanordnung (1) eingesetzt ist, und Verbinden (220) der Substrate (90) und der elementaren Leistungsanordnung (1) miteinander, und
- Füllen (230) einer etwaigen verbleibenden Lücke zwischen den Substraten mit elektrisch isolierendem Material (95).

9. Verfahren zur Herstellung eines Leistungsmoduls (9) nach Anspruch 8, wobei das während des Füllschritts (230) verwendete elektrisch isolierende Material (95) Klebstoff ist, um die Substrate (90) zusammenzuhalten.

10. Verfahren zur Herstellung eines Leistungsmoduls (9) nach einem der Ansprüche 8 oder 9, wobei die elementaren Leistungsanordnung erhalten wird durch:
- Ausbilden (100) einer Basisstruktur (80), welche aufweist:
o einen elektrisch isolierenden Kern (20),
o ein Leistungsbauteil (10), das zumindest zwei elektrische Kontakte (11) aufweist, wobei das Leistungsbauteil in den elektrisch isolierenden Kern (20) eingebettet ist, und
o zwei externe Lagen (60) von elektrisch leitfähigem Material auf entgegengesetzten Hauptoberflächen des elektrisch isolierenden Kerns (20), und
- Ausbilden (110) in der Basisstruktur (80) einer offenen Vertiefung (40), die einen Bereich eines elektrischen Kontakts (11) des Leistungsbauteils (10) freilegt, indem von der Basisstruktur (80) ein Stapel entfernt wird, der einen dem elektrischen Kontakt (11) benachbarten Abschnitt des elektrisch isolierenden Kerns (20), sowie einen Abschnitt der externen Lage (60) von elektrisch leitfähigem Material, die den Abschnitt des elektrisch isolierenden Kerns abdeckt, aufweist, und
- zumindest teilweises Beschichten (120) der offenen Vertiefung (40), um den Bereich des elektrischen Kontakts (11) des Leistungsbauteils (10) mit der externen Lage (60) von elektrisch leitfähigem Material zu verbinden.

11. Das Verfahren nach Anspruch 10, wobei der Beschichtungsschritt (200) durchgeführt wird, indem eine zusätzliche Lage von elektrisch leitfähigem Material (31) auf jener Seite der Basisstruktur abgelagert wird, in der die offene Vertiefung (40) ausgebildet ist, wobei die zusätzliche Lage (31) von elektrisch leitfähigem Material die externe Lage (60) von elektrisch leitfähigem Material, einen durch den freiliegenden Bereich des elektrischen Leistungsbauteilkontakts (11) gebildeten Boden (41) der offenen Vertiefung sowie seitliche Wände (43) der offenen Vertiefung (40) bedeckt.

12. Verfahren nach einem der Ansprüche 10 oder 11, wobei das Leistungsbauteil (10) an einer selben Seite zwei elektrische Kontakte (11) aufweist, und das Verfahren aufweist, offene Vertiefungen (40) auszubilden, um jeweils einen Bereich des elektrischen Kontakts (11) derselben Seite des Leistungsbauteils freizulegen,
und das Verfahren ferner, nach dem Beschichtungsschritt (120), einen Schritt (120) zum Bemustern der zusätzlichen Lage (31) von elektrisch leitfähigem Material aufweist, um die zwei elektrischen Kontakte (11) derselben Seite des Leistungsbauteils (10) zu trennen.

13. Verfahren nach einem der Ansprüche 10 bis 12, wobei der Schritt (100) der Ausbildung der Basisstruktur (80) aufweist:
- Ausbilden (101) von zumindest einer Durchgangsvertiefung (250) der Größe des Leistungsbauteils (10) in der Basislage (25) von elektrisch isolierendem Material,
- Einsetzen (102) des Leistungsbauteils (10) in die Durchgangsvertiefung (250),
- Positionieren (102) der das Leistungsbauteil (10) aufweisenden Basislage (25) zwischen zwei zusätzlichen Lagen (26) von elektrisch isolierendem Material, um einen Stapel (27) von elektrisch isolierenden Lagen zu erhalten, und Positionieren des Stapels (27) von elektrisch isolierenden Lagen zwischen zwei externen Lagen (60) von elektrisch leitfähigem Material, und
- Laminieren (104) des Stapels (27) von elektrisch isolierenden Lagen und der externen Lagen (60) von elektrisch leitfähigem Material.

## Revendications

1. Module de puissance (9), comprenant un ensemble de puissance électrique (1), l'ensemble de puissance électrique (1) comprenant :
- une puce de puissance (10), ayant au moins deux contacts électriques (11),
- un cœur électriquement isolant (20), dans lequel la puce de puissance (10) est incorporée dans le cœur électriquement isolant (20), et
- deux couches (60, 30) de matériau électriquement conducteur sur des surfaces principales opposées du cœur électriquement isolant (20),
- au moins une cavité ouverte (40) s'étendant à partir d'un contact électrique (11) de la puce de puissance, à travers le cœur électriquement isolant (20) et la couche (60, 30) de matériau électriquement conducteur située sur le même côté de la puce de puissance que le contact électrique, de sorte que la cavité ouverte (40) possède un fond (41) formé par une zone du contact électrique (11) de la puce de puissance, dans lequel le fond (41) et les parois latérales (43) de la cavité ouverte (40) sont au moins partiellement plaqués avec un matériau électriquement conducteur pour connecter ladite zone du contact électrique (11) de la puce de puissance (10) à la couche (60, 30) de matériau électriquement conducteur,
**caractérisé en ce que**
le module de puissance (9) comprend également au moins un substrat (90) comprenant une couche de matériau thermiquement conducteur et électriquement isolant (92) et une couche (91) de matériau électriquement conducteur,
le substrat (90) comprenant en outre au moins un plot (93) de matériau électriquement conducteur faisant saillie à partir de la couche de matériau électriquement conducteur (91), et l'ensemble de puissance électrique (1) étant monté sur le substrat (90) de sorte que le plot (93) soit inséré dans la cavité ouverte (40) de l'ensemble de puissance électrique (1),
ledit plot (93) ayant une géométrie et des dimensions adaptées à la géométrie et aux dimensions de la cavité ouverte (40) de l'ensemble de puissance électrique (1), de sorte que l'insertion du plot dans ladite cavité ouverte (40) fournisse un contact électrique et thermique entre le plot (93) et le contact électrique (11) de la puce de puissance (10) à partir duquel la cavité ouverte (40) s'étend.

2. Module de puissance (9) selon la revendication 1, dans lequel, dans l'ensemble de puissance électrique (1), la couche (60) de matériau électriquement conducteur, et le fond (41) et les parois latérales (43) de la cavité sont intégralement plaqués avec un matériau électriquement conducteur.

3. Module de puissance (9) selon l'une quelconque des revendications précédentes, dans lequel l'ensemble de puissance électrique (1) comprend au moins deux cavités ouvertes (40), chaque cavité s'étendant à partir d'un contact respectif parmi les contacts électriques (11) de la puce de puissance (10).

4. Module de puissance (9) selon l'une quelconque des revendications précédentes, dans lequel, dans l'ensemble de puissance électrique (1), la surface de la zone du contact électrique (11) de puce de puissance formant le fond de la cavité ouverte (40) est comprise entre 10 et 100 % de la surface du contact électrique (11) de puce de puissance, et est strictement inférieure à la surface du côté de la puce de puissance (10) sur lequel le contact électrique (11) est situé.

5. Module de puissance (9) selon l'une quelconque des revendications précédentes, dans lequel l'ensemble de puissance électrique (1) comprend au moins deux cavités ouvertes (40) s'étendant à partir d'un même contact électrique (11) de la puce de puissance, chaque cavité ayant un fond formé par une zone respective du contact électrique (11) de puce de puissance, la surface de la zone du contact électrique formée par le fond de chaque cavité ouverte est comprise entre 1 et 100 % de la surface du contact électrique, et la surface cumulée des zones du contact électrique formant les fonds des cavités est comprise entre 10 et 100 % de la surface du contact électrique (11), et est inférieure à la surface du côté de la puce de puissance (10) sur lequel le contact électrique (11) est situé.

6. Module de puissance (9) selon l'une quelconque des revendications précédentes, dans lequel le plot (93) possède des géométries et des dimensions adaptées à la géométrie et aux dimensions de la cavité ouverte (40) de l'ensemble de puissance électrique (1), de sorte que l'insertion du plot dans ladite cavité ouverte (40) fournisse en outre un contact électrique entre le plot (93) et les parois plaquées (43) de la cavité et entre la couche de matériau électriquement conducteur (91) du substrat et une couche de surface (30) de matériau électriquement conducteur de l'ensemble de puissance électrique (1) adjacente à ladite cavité ouverte (40).

7. Module de puissance (9) selon l'une quelconque des revendications précédentes, comprenant deux substrats (90) comprenant chacun une couche (92) de matériau thermiquement conducteur et électriquement isolant et une couche (91) de matériau électriquement conducteur ayant un plot (93) faisant saillie à partir de celle-ci, et dans lequel l'ensemble de puissance électrique (1) comprend des cavités ouvertes (40) sur des côtés opposés de celui-ci,
l'ensemble de puissance électrique étant monté entre les deux substrats (90) avec chaque plot (93) d'un substrat (90) inséré dans une cavité respective (40) de l'ensemble de puissance (1), et le module de puissance comprend en outre un matériau électriquement isolant remplissant les espaces qui subsistent entre les substrats.

8. Procédé pour la fabrication d'un module de puissance (9) selon l'une quelconque des revendications précédentes, comprenant :
- la fourniture (200) de deux substrats (90), chaque substrat (90) comprenant une couche (92) de matériau thermiquement conducteur et électriquement isolant et une couche (91) de matériau électriquement conducteur, et un ensemble de puissance élémentaire (1) ayant au moins une cavité ouverte (40) sur des côtés principaux opposés de celui-ci,
- sur chaque substrat (90), la formation (210) d'au moins un plot (93) de matériau électriquement conducteur faisant saillie à partir de la couche de matériau électriquement conducteur (91), chaque plot (93) ayant une géométrie et des dimensions adaptées à la géométrie et aux dimensions d'une cavité ouverte (40) respective de l'ensemble de puissance élémentaire (1),
- le montage de l'ensemble de puissance élémentaire (1) entre les substrats (90) avec le plot (93) de chaque substrat inséré dans une cavité ouverte (40) correspondante de l'ensemble de puissance élémentaire (1), et la liaison (220) des substrats (90) et de l'ensemble de puissance élémentaire (1) entre eux, et
- le remplissage (230) de tout espace subsistant entre les substrats avec un matériau électriquement isolant (95).

9. Procédé pour la fabrication d'un module de puissance (9) selon la revendication 8, dans lequel le matériau électriquement isolant (95) utilisé lors de l'étape de remplissage (230) est adhésif afin de maintenir ensemble les substrats (90).

10. Procédé pour la fabrication d'un module de puissance (9) selon l'une quelconque des revendications 8 ou 9, dans lequel l'ensemble de puissance élémentaire est obtenu par :
- la formation (100) d'une structure de base (80) comprenant :
o un cœur électriquement isolant (20),
o une puce de puissance (10), ayant au moins deux contacts électriques (11), la puce de puissance étant incorporée dans le cœur électriquement isolant (20) et,
o deux couches externes (60) de matériau électriquement conducteur sur des surfaces principales opposées du cœur électriquement isolant (20), et
- la formation (110), dans la structure de base (80), d'une cavité ouverte (40) exposant une zone d'un contact électrique (11) de la puce de puissance (10), par le retrait, à partir de la structure de base (80), d'un empilement comprenant une portion du cœur électriquement isolant (20) adjacent audit contact électrique (11), et une portion de la couche externe (60) de matériau électriquement conducteur recouvrant ladite portion du cœur électriquement isolant, et
- le placage (120), au moins partiellement, de la cavité ouverte (40) afin de connecter ladite zone du contact électrique (11) de la puce de puissance (10) à la couche externe (60) de matériau électriquement conducteur.

11. Procédé selon la revendication 10, dans lequel l'étape de placage (200) est réalisée par le dépôt d'une couche supplémentaire de matériau électriquement conducteur (31) sur le côté de la structure de base dans lequel la cavité ouverte (40) est formée, ladite couche supplémentaire (31) de matériau électriquement conducteur recouvrant la couche externe (60) de matériau électriquement conducteur, un fond (41) de la cavité ouverte formé par la zone exposée du contact électrique (11) de puce de puissance, et les parois latérales (43) de la cavité ouverte (40).

12. Procédé selon l'une quelconque des revendications 10 ou 11, dans lequel la puce de puissance (10) possède deux contacts électriques (11) sur un même côté de celle-ci, et le procédé comprend la formation de cavités ouvertes (40) pour exposer respectivement une zone de chaque contact électrique (11) du même côté de la puce de puissance,
et le procédé comprend en outre, après l'étape de placage (120), une étape (130) de formation de motifs sur la couche supplémentaire (31) de matériau électriquement conducteur afin de déconnecter les deux contacts électriques (11) du même côté de la puce de puissance (10).

13. Procédé selon l'une quelconque des revendications 10 à 12, dans lequel l'étape (100) de formation de la structure de base (80) comprend :
- la formation (101) d'au moins une cavité traversante (250) de la taille de la puce de puissance (10) dans une couche de base (25) de matériau électriquement isolant,
- l'insertion (102) de la puce de puissance (10) dans la cavité traversante (250),
- le positionnement (102) de la couche de base (25) comprenant la puce de puissance (10) entre deux couches supplémentaires (26) de matériau électriquement isolant, pour obtenir un empilement (27) de couches électriquement isolantes, et le positionnement dudit empilement (27) de couches électriquement isolantes entre deux couches externes (60) de matériau électriquement conducteur, et
- la stratification (104) de l'empilement (27) de couches électriquement isolantes et des couches externes (60) de matériau électriquement conducteur.
